# EUROPEAN PATENT APPLICATION

(11) **EP 4 723 831 A1**
(43) Date of publication of application: **08.04.2026**
(21) Application number: 25204333.6
(22) Date of filing: 24.09.2025
(51) Int. Cl.: H10D 30/47, H10D 30/01, H10D 62/80, H10D 64/27, H10D 64/68, H10D 84/83

(54) **SEMICONDUCTOR DEVICE, ELECTRONIC APPARATUS INCLUDING SEMICONDUCTOR DEVICE, AND METHOD OF MANUFACTURING SEMICONDUCTOR DEVICE**

(30) Priority: 02.10.2024 KR 20240134216
(71) Applicant: Samsung Electronics Co., Ltd., Suwon-si, Gyeonggi-do 16677 (KR)
(72) Inventor: Kim, Changhyun, 16678 Suwon-si, Gyeonggi-do (KR); Yang, Eunji, 16678 Suwon-si, Gyeonggi-do (KR); Lee, Eunkyu, 16678 Suwon-si, Gyeonggi-do (KR)
(74) Representative: Grünecker Patent- und Rechtsanwälte PartG mbB

(57) **Abstract**

A semiconductor device includes a channel including a two-dimensional semiconductor material, a source electrode and a drain electrode electrically connected to both ends of the channel, respectively, a two-dimensional material oxide layer on the channel, a dipole oxide layer on the two-dimensional material oxide layer, a dielectric layer on the dipole oxide layer, and a gate electrode on the dielectric layer.

## Description

### BACKGROUND

### 1. Field

The disclosure relates to a semiconductor devices with an adjustable threshold voltage, electronic apparatuses including the semiconductor device, and methods of manufacturing the semiconductor device.

### 2. Description of the Related Art

As semiconductor devices performing an electrical switching function, transistors have been used in various integrated circuit (IC) devices including memories, driving ICs, logic devices, and/or the like. In order to increase the degree of integration of an IC device, the space occupied by transistors provided therein has rapidly decreased. As a result, the channel length of transistors has decreased and the thickness of layers constituting transistors has decreased. Accordingly, research has been conducted to maintain desired performance while reducing the size of transistors.

### SUMMARY

The invention is claimed in the independent claims. Preferred embodiments are specified in the dependent claims.

Some example embodiments provide semiconductor devices with an adjustable threshold voltage.

Some example embodiments provide electronic apparatuses including a semiconductor device with an adjustable threshold voltage.

Some example embodiments provide methods of manufacturing a semiconductor device with an adjustable threshold voltage.

Additional aspects will be set forth in part in the description which follows and, in part, will be apparent from the description, or may be learned by practice of the presented example embodiments of the disclosure.

According to an example embodiment of the disclosure, a semiconductor device includes a channel including a two-dimensional semiconductor material, a source electrode and a drain electrode electrically connected to both ends of the channel, respectively, a two-dimensional material oxide layer on the channel, a dipole oxide layer on the two-dimensional material oxide layer, a dielectric layer on the dipole oxide layer, and a gate electrode on the dielectric layer, wherein the dipole oxide layer includes at least one of La₂O₃, Al₂O₃, ScO, Y₂O₃, and MgO, or the dielectric layer includes at least one of HfO₂, ZrO₂, or HfZrO.

The dipole oxide layer may be in contact with the two-dimensional material oxide layer.

The channel may include at least one of a transition metal dichalcogenide (TMD) material, graphene, black phosphorus, amorphous boron nitride, or phosphorene.

The TMD material may include a metal element selected from among Mo, W, Nb, V, Ta, Ti, Zr, Hf, Tc, Re, Cu, Ga, In, Sn, Ge, and Pb, and a chalcogen element selected from among S, Se, and Te.

The two-dimensional material oxide layer may include an oxide of a material included in the channel.

A thickness of the two-dimensional material oxide layer may be greater than about 0 nm but not more than about 2 nm.

A thickness of the dipole oxide layer may be greater than about 0 nm but not more than about 2 nm.

A thickness of the dielectric layer may be greater than about 0 nm but not more than about 5 nm.

The semiconductor device may further include a substrate supporting the channel, wherein the gate electrode may surround the channel while being apart from the channel, and between the gate electrode and the channel, the two-dimensional material oxide layer may surround the channel, the dipole oxide layer may surround the two-dimensional material oxide layer, and the dielectric layer may surround the dipole oxide layer.

The channel may include a first channel layer and a second channel layer spaced apart from each other in a direction away from the substrate, the two-dimensional material oxide layer may include a first two-dimensional material oxide layer surrounding the first channel layer and a second two-dimensional material oxide layer surrounding the second channel layer, the dipole oxide layer may include a first dipole oxide layer surrounding the first two-dimensional material oxide layer and a second dipole oxide layer surrounding the second two-dimensional material oxide layer, and the dielectric layer may include a first dielectric layer surrounding the first dipole oxide layer and a second dielectric layer surrounding the second dipole oxide layer.

The first two-dimensional material oxide layer, the first dipole oxide layer, the second two-dimensional material oxide layer, and the second dipole oxide layer may be different in terms of at least one of material and thickness.

A first electric dipole moment at an interface between the first two-dimensional material oxide layer and the first dipole oxide layer and a second electric dipole moment at an interface between the second two-dimensional material oxide layer and the second dipole oxide layer may be different in at least one of magnitude or polarity.

The first channel layer and the second channel layer may include different materials from each other.

The semiconductor device may include a source structure including the source electrode and connecting the source electrode to the channel, and a drain structure including the drain electrode and connecting the drain electrode to the channel, wherein the source structure and the drain structure may be arranged over the substrate.

Each of the source structure and the drain structure may include a semiconductor region, a silicide layer, and a conductive barrier.

According to an example embodiment of the disclosure, an electronic apparatus includes a substrate, and a plurality of semiconductor devices on the substrate, wherein each of the plurality of semiconductor devices includes a channel including a two-dimensional semiconductor material, a source electrode and a drain electrode electrically connected to both ends of the channel, respectively, a two-dimensional material oxide layer on the channel, a dipole oxide layer on the two-dimensional material oxide layer, a dielectric layer on the dipole oxide layer, and a gate electrode on the dielectric layer, wherein the dipole oxide layer includes at least one of La₂O₃, Al₂O₃, ScO, Y₂O₃, or MgO, and the dielectric layer includes at least one of HfO₂, ZrO₂, or HfZrO.

In each of the plurality of semiconductor devices, the channel may include a plurality of channel layers spaced apart from each other in a direction away from the substrate, the two-dimensional material oxide layer may include a plurality of two-dimensional material oxide layers surrounding the plurality of channel layers, respectively, the dipole oxide layer may include a plurality of dipole oxide layers surrounding the plurality of two-dimensional material oxide layers, respectively, and the dielectric layer may include a plurality of dielectric layers surrounding the plurality of dipole oxide layers, respectively.

According to an example embodiment of the disclosure, a method of manufacturing a semiconductor device includes alternately forming a dummy layer and a channel on a substrate, to form a stack structure, the channel including a two-dimensional semiconductor material, forming a source electrode and a drain electrode on both sides of the stack structure, respectively, removing the dummy layer, forming a two-dimensional material oxide layer on the channel, forming a dipole oxide layer on the two-dimensional material oxide layer, forming a dielectric layer on the dipole oxide layer, and forming a gate electrode over the dielectric layer, wherein the dipole oxide layer includes at least one of La₂O₃, Al₂O₃, ScO, Y₂O₃, or MgO, and the dielectric layer includes at least one of HfO₂, ZrO₂, or HfZrO.

### BRIEF DESCRIPTION OF THE DRAWINGS

The above and other aspects, features, and advantages of certain example embodiments of the disclosure will be more apparent from the following description taken in conjunction with the accompanying drawings, in which:
FIG. 1 is a cross-sectional view illustrating a schematic structure of a semiconductor device according to an example embodiment;
FIGS. 2A and 2B are conceptual diagrams describing an electric dipole moment formed at an interface between a two-dimensional material oxide layer and a dipole oxide layer of the semiconductor device of FIG. 1;
FIG. 3 illustrates dipole moments of various materials as examples;
FIG. 4 is a perspective view illustrating a schematic structure of a semiconductor device according to an example embodiment;
FIG. 5 is a cross-sectional view taken along line AA of FIG. 4;
FIG. 6 is a cross-sectional view taken along line BB of FIG. 4;
FIG. 7 is a perspective view illustrating a schematic structure of a semiconductor device according to an example embodiment;
FIG. 8 is a cross-sectional view taken along line AA of FIG. 7;
FIG. 9 is a cross-sectional view taken along line BB of FIG. 7;
FIG. 10 is a cross-sectional view illustrating a schematic structure of a semiconductor device according to an example embodiment;
FIG. 11 is a cross-sectional view illustrating a schematic structure of a semiconductor device according to an example embodiment;
FIGS. 12A to 12G are diagrams describing a semiconductor device manufacturing method according to an example embodiment;
FIG. 13 is a schematic block diagram of a display driver integrated circuit (IC) (DDI) and a display apparatus including the DDI according to an example embodiment;
FIG. 14 is a circuit diagram of a complementary metal oxide semiconductor (CMOS) inverter according to an example embodiment;
FIG. 15 is a circuit diagram of a CMOS static random access memory (SRAM) device according to an example embodiment;
FIG. 16 is a circuit diagram of a CMOS NAND circuit according to an example embodiment;
FIG. 17 is a block diagram of an electronic apparatus according to an example embodiment; and
FIG. 18 is a block diagram of an electronic apparatus according to an example embodiment.

### DETAILED DESCRIPTION

Reference will now be made in detail to example embodiments, examples of which are illustrated in the accompanying drawings, wherein like reference numerals refer to like elements throughout. In this regard, the present example embodiments may have different forms and should not be construed as being limited to the descriptions set forth herein. Accordingly, the example embodiments are merely described below, by referring to the figures, to explain some aspects. As used herein, the term "and/or" includes any and all combinations of one or more of the associated listed items. Expressions such as "one of," "any one of," and "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

Hereinafter, some embodiments will be described in detail with reference to the accompanying drawings. The described example embodiments are merely examples, and various modifications may be made therein. Like reference numerals in the drawings will denote like elements, and sizes of elements in the drawings may be exaggerated for clarity and convenience of description.

As used herein, the terms "over" or "on" may include not only "directly over" or "directly on" but also "indirectly over" or "indirectly on".

Although terms such as "first" and "second" may be used herein to describe various elements, these terms are only used to distinguish an element from another element. These terms are not intended to limit that the materials or structures of elements are different from each other.

As used herein, the singular forms "a", "an", and "the" are intended to include the plural forms as well, unless the context clearly indicates otherwise. Also, when something is referred to as "including" a component, another component may be further included unless specified otherwise.

Also, as used herein, the terms "units" and "modules" may refer to units that perform at least one function or operation, and the units may be implemented as hardware or software or a combination of hardware and software.

The use of the terms "a", "an", and "the" and other similar indicative terms may be construed to cover both the singular and the plural.

Operations of a method described herein may be performed in any suitable order unless otherwise specified. Also, example terms (e.g., "such as" and "and/or the like") used herein are merely intended to describe the technical concepts of the disclosure in detail, and the scope of the disclosure is not limited by the example terms unless otherwise defined in the appended claims.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

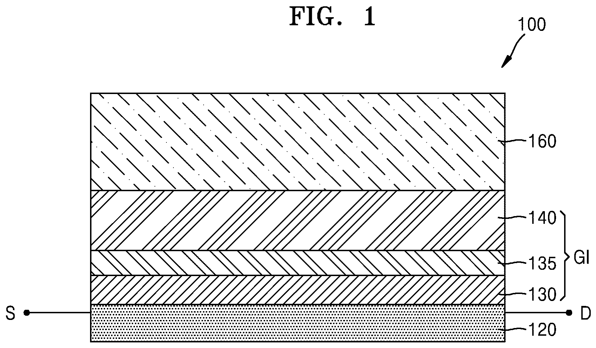

FIG. 1 is a cross-sectional view illustrating a schematic structure of a semiconductor device according to an example embodiment.

A semiconductor device 100 may include a channel 120, a gate electrode 160 provided apart from the channel 120, and a gate insulating layer GI between the channel 120 and the gate electrode 160. The gate insulating layer GI may include a two-dimensional material oxide layer 130, a dipole oxide layer 135 provided over the two-dimensional material oxide layer 130, and a dielectric layer 140 provided over the dipole oxide layer 135. Also, the semiconductor device 100 may include a source electrode S electrically connected to one side of the channel 120 and a drain electrode D electrically connected to the other side of the channel 120. The source electrode S and the drain electrode D may be directly connected to the channel 120 or may be electrically connected through another layer, and the positions of the source electrode S and the drain electrode D may also be variously implemented.

The channel 120 may include a two-dimensional semiconductor material. The channel 120 may include, for example, at least one of a transition metal dichalcogenide (TMD) material, graphene, black phosphorus, amorphous boron nitride, or phosphorene. The TMD may include, for example, at least one transition metal among Mo, W, Nb, V, Ta, Ti, Zr, Hf, Tc, and Re, and at least one chalcogen element among S, Se, and Te. The TMD may be represented as, for example, MX₂, where M denotes a transition metal and X denotes a chalcogen element. For example, M may include at least one of Mo, W, Nb, V, Ta, Ti, Zr, Hf, Tc, or Re, and X may include at least one of S, Se, or Te. For example, the TMD may include at least one of MoS₂, MoSe₂, MoTe₂, WS₂, WSe₂, WTe₂, ZrS₂, ZrSe₂, HfS₂, HfSe₂, NbSe₂, or ReSe₂. Alternatively, the TMD may not be represented as MX₂. In this case, for example, the TMD may include CuS that is a compound of Cu that is a transition metal and S that is a chalcogen element. However, the materials mentioned above are merely examples, and other materials may be used as the TMD material.

The two-dimensional semiconductor material may be doped with a p-type dopant or an n-type dopant to adjust the mobility thereof. Here, for example, a p-type dopant and an n-type dopant used in graphene or carbon nanotube (CNT) may be used as the p-type dopant and the n-type dopant described above. The p-type dopant or the n-type dopant described above may be doped by using ion implantation or chemical doping.

The gate electrode 160 may include a metal material or a conductive oxide. The metal material may include, for example, at least one selected from among Au, Ti, TiN, TaN, W, Mo, WN, Pt, and Ni. The conductive oxide may include, for example, indium tin oxide (ITO) or indium zinc oxide (IZO). The gate electrode 160 may include polysilicon or monocrystalline silicon. The gate electrode 160 may include the same material as the source electrode S and the drain electrode D. However, the disclosure is not limited thereto, and the gate electrode 160 may include a different material than the source electrode S and the drain electrode D.

The use of a two-dimensional semiconductor material in the channel 120 may be to implement a short channel length when the semiconductor device 100 is applied as a field effect transistor. The channel length may refer to the length of the channel 120 in a direction in which the source electrode S and the drain electrode D are spaced apart from each other. Recently, the channel length has gradually decreased according to the trend of miniaturization of electronic apparatuses. It is known that problems due to the short channel effect are caused as the channel length decreases. In order to reduce or prevent the problems due to the short channel effect and/or effectively reduce the channel length, it may be advantageous to reduce the thickness of the channel 120. In other words, as the length of the channel 120 decreases, the minimum channel length that is implementable may decrease.

The two-dimensional semiconductor material may have relatively good electrical properties and may maintain relatively high mobility without significantly changing its characteristics even when its thickness decreases to the nanoscale. The two-dimensional semiconductor material may have a monolayer or multilayer structure. Each layer constituting the two-dimensional semiconductor material may have an atomic-level thickness. The thickness of the channel 120 may be greater than about 0 nm but not more than about 10 nm, not more than about 5 nm, or not more than about 3 nm. The thickness of the channel 120 is not limited thereto and may be smaller. The length of the channel 120 (e.g., the length of the channel 120 in a direction in which the source electrode S and the drain electrode D are spaced apart from each other) may be greater than about 0 nm but not more than about 5 nm, not more than about 4 nm, or not more than about 3 nm. This is an example and the present disclosure is not limited thereto. As the thickness of the channel 120 decreases, the length of the channel 120 may decrease.

When a two-dimensional semiconductor material is applied to the channel 120, it may be difficult to form the dielectric layer 140 provided between the channel 120 and the gate electrode 160. For example, the TMD material may be a two-dimensional material including a Van der Waals bond and may have the advantage of having a stable structure without a dangling bond with three atoms forming one layer. However, it may be difficult to deposit a dielectric material thereover because it has no dangling bond.

The semiconductor device 100 according to an example embodiment may use the two-dimensional material oxide layer 130, the dipole oxide layer 135, and the dielectric layer 140 as the gate insulating layer GI.

The two-dimensional material oxide layer 130 may include a transition metal oxide. The transition metal oxide may include, for example, at least one of Ti oxide, Ta oxide, Ni oxide, Zn oxide, W oxide, Co oxide, Nb oxide, TiNi oxide, LiNi oxide, InZn oxide, V oxide, SrZr oxide, SrTi oxide, Cr oxide, Fe oxide, Cu oxide, Hf oxide, Zr oxide, Al oxide, or any mixture thereof. The two-dimensional material oxide layer 130 may include, for example, MoOₓ or WOₓ.

When the channel 120 includes a TMD material, the two-dimensional material oxide layer 130 may be an oxide of the TMD material included in the channel 120. In this case, the transition metal included in the TMD material included in the channel 120 and the transition metal included in the two-dimensional material oxide layer 130 may be the same as each other.

The thickness of the two-dimensional material oxide layer 130 may be greater than about 0 nm but not more than about 2 nm. The thickness of the two-dimensional material oxide layer 130 may be, for example, a thickness corresponding to a monolayer of the two-dimensional material included in the channel 120 or may be in a range similar thereto. However, the present disclosure is not limited thereto.

The dipole oxide layer 135 may be provided to directly contact the two-dimensional material oxide layer 130. However, the disclosure is not limited thereto, and another layer may also be arranged therebetween.

The dipole oxide layer 135 may include at least one of La oxide, Al oxide, Sc oxide, Y oxide, or Mg oxide. The dipole oxide layer 135 may include, for example, at least one of La₂O₃, Al₂O₃, ScO, Y₂O₃, or MgO. The thickness of the dipole oxide layer 135 may be greater than about 0 nm but not more than about 2 nm.

The two-dimensional material oxide layer 130 and the dipole oxide layer 135 may have different oxygen densities. The two-dimensional material oxide layer 130 and the dipole oxide layer 135 may have, for example, different areal oxygen densities. The areal oxygen density may refer to the number of oxygen atoms per unit area. The difference between the areal oxygen densities may cause a structural imbalance at the interface between the two-dimensional material oxide layer 130 and the dipole oxide layer 135. The structural imbalance may be reduced through the movement of oxygen atoms. That is, the oxygen atoms may move from a layer with a high areal oxygen density to a layer with a low areal oxygen density among the two-dimensional material oxide layer 130 and the dipole oxide layer 135. The moving oxygen atoms may be in the form of O²⁻ anions. The movement of oxygen atoms may cause an oxygen vacancy in a layer with a higher areal oxygen density and may cause excess oxygen in a layer with a lower areal oxygen density among the two-dimensional material oxide layer 130 and the dipole oxide layer 135. Thus, the layer with a low areal oxygen density among the two layers may be negatively charged, and the layer with a high areal oxygen density may be positively charged. Accordingly, an electric dipole in the direction from the negative charge to the positive charge may be generated at the interface between the two-dimensional material oxide layer 130 and the dipole oxide layer 135. Such an electric dipole moment may raise or lower the Fermi energy level E_{f} of the dipole oxide layer 135, and accordingly, the work function of the gate electrode 160 may change. The change of the work function of the gate electrode 160 may affect the threshold voltage of the channel 120. The threshold voltage of the semiconductor device 100 may be changed by changing the oxygen density of the two-dimensional material oxide layer 130 and the dipole oxide layer 135. The oxygen density of the two-dimensional material oxide layer 130 and the dipole oxide layer 135 may be controlled by changing at least one of the material or thickness of the corresponding layer.

The dielectric layer 140 may include a high-k material or a ferroelectric material. The high-k material may refer to a dielectric constant higher than the dielectric constant of silicon oxide. The dielectric layer 140 may include at least one of HfO₂, ZrO₂, CeO₂, Ta₂O₃, TiO₂, or HfZrO. The dielectric layer 140 may have a monolayer structure as illustrated but is not limited thereto and may also have a multilayer structure. For example, the dielectric layer 140 may have a multilayer structure of ZrO₂/HfO₂/ZrO₂/HfO₂. The thickness of the dielectric layer 140 may be greater than about 0 nm but not more than about 5 nm.

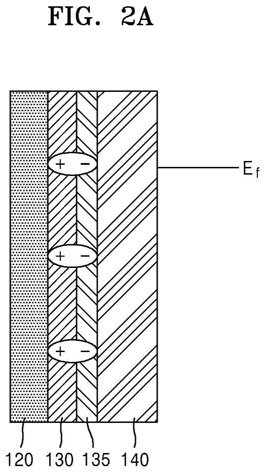

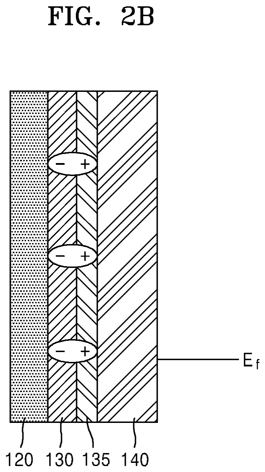

FIGS. 2A and 2B are conceptual diagrams describing an electric dipole moment formed at an interface between the two-dimensional material oxide layer 130 and the dipole oxide layer 135 of the semiconductor device 100 of FIG. 1.

Referring to FIG. 2A, when the areal oxygen density of the two-dimensional material oxide layer 130 is greater than the areal oxygen density of the dipole oxide layer 135, anion oxygen atoms may move from the two-dimensional material oxide layer 130 to the dipole oxide layer 135. Accordingly, an electric dipole may be generated at the interface between the two-dimensional material oxide layer 130 and the dipole oxide layer 135 in the direction from the negative charge to the positive charge, that is, in the direction from the dipole oxide layer 135 to the two-dimensional material oxide layer 130. The dipole oxide layer 135 may have a Fermi energy level E_{f} corresponding thereto.

Referring to FIG. 2B, when the areal oxygen density of the dipole oxide layer 135 is greater than the areal oxygen density of the two-dimensional material oxide layer 130, anion oxygen atoms may move from the dipole oxide layer 135 to the two-dimensional material oxide layer 130. Accordingly, an oxygen vacancy may be formed in the dipole oxide layer 135, and the two-dimensional material oxide layer 130 may be in an excess-oxygen state. Accordingly, an electric dipole may be generated at the interface between the two-dimensional material oxide layer 130 and the dipole oxide layer 135 in the direction from the negative charge to the positive charge, that is, in the direction from the two-dimensional material oxide layer 130 to the dipole oxide layer 135. The dipole oxide layer 135 may have a Fermi energy level E_{f} corresponding thereto.

The change of the Fermi energy level E_{f} illustrated in FIGS. 2A and 2B may be an example. The magnitude and direction of the electric dipole moment generated at the interface of the two-dimensional material oxide layer 130 and the dipole oxide layer 135 may be variously adjusted by the areal oxygen density of the two-dimensional material oxide layer 130, the areal oxygen density of the dipole oxide layer 135, the difference between the areal oxygen density of the two-dimensional material oxide layer 130 and the areal oxygen density of the dipole oxide layer 135, or the like. Accordingly, the Fermi energy level E_{f} of the dipole oxide layer 135 may be adjusted, and the work function of the gate electrode 160 located over the dipole oxide layer 135 may be adjusted.

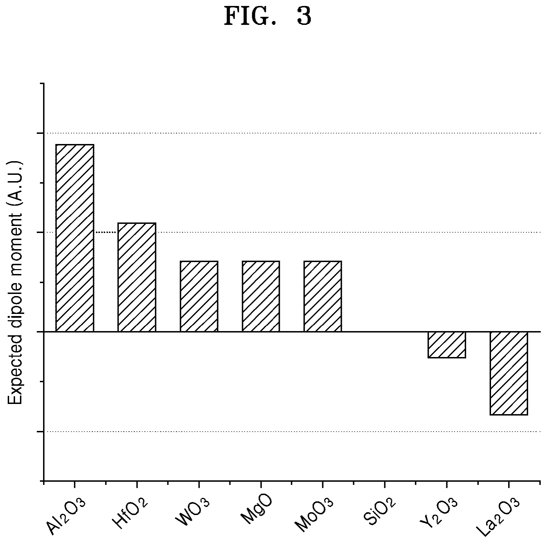

FIG. 3 illustrates examples of dipole moments of various materials applicable to the gate insulating layer GI of the semiconductor device 100 of FIG. 1.

The illustrated materials are transition metal oxide that may be used in the two-dimensional material oxide layer 130 and materials that may be used in the dipole oxide layer 135. The dipole oxide layer 135 may include at least one of LaO, AIO, ScO, Y₂O₃, and MgO. A suitable combination of materials suitable for the threshold voltage that the semiconductor device 100 is intended to implement may be selected and applied to the gate insulating layer GI.

As described above, the semiconductor device 100 illustrated in FIG. 1 may adjust the work function of the gate electrode 160 by using the two-dimensional material oxide layer 130 and the dipole oxide layer 135, and may be applied as a field effect transistor that exhibits a desired threshold voltage. The semiconductor device 100 may also exhibit various threshold voltages and therefore may be applied to a device that implements a multi-threshold voltage that is convenient for logic design. The semiconductor device 100 may have various threshold voltages and reduce a leakage current by including the two-dimensional material oxide layer 130, the dipole oxide layer 135, and the dielectric layer 140 as the gate insulating layer GI. The dipole oxide layer 135 may be configured to induce a dipole moment at the interface with the two-dimensional material oxide layer 130 to have a multiple threshold voltage. Also, the dielectric layer 140 may be configured to collect a lot of electrons and reduce a leakage current.

The semiconductor device 100 of FIG. 1 is illustrated as having the channel 120 in a planar shape but is not limited thereto and may be applied as a FinFET, a gate-all-around FET (GAAFET), or a multi-bridge channel FET (MBCFET) having a three-dimensional channel structure to increase a current and/or facilitate gate control.

Hereinafter, semiconductor devices and electronic apparatuses according to various example embodiments will be described.

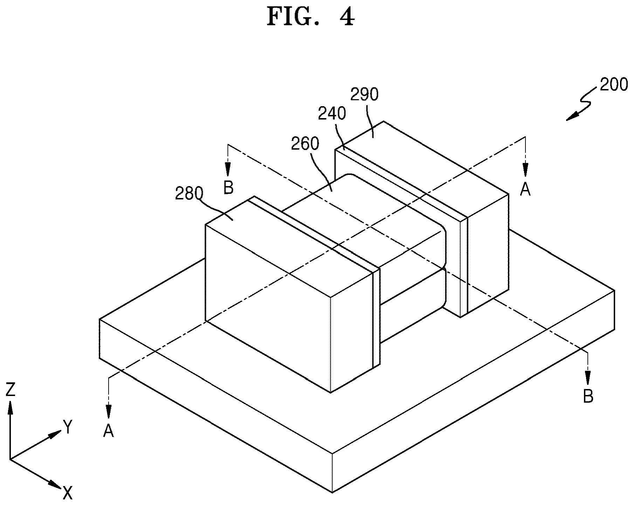

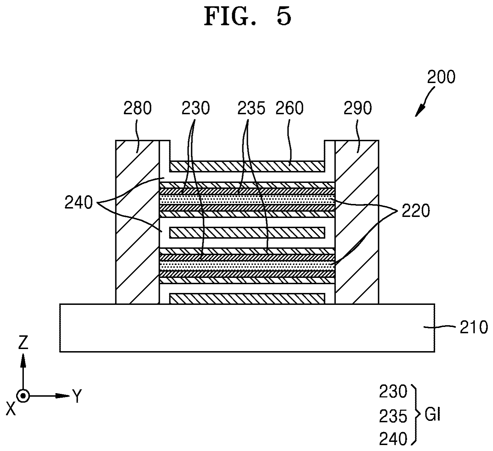

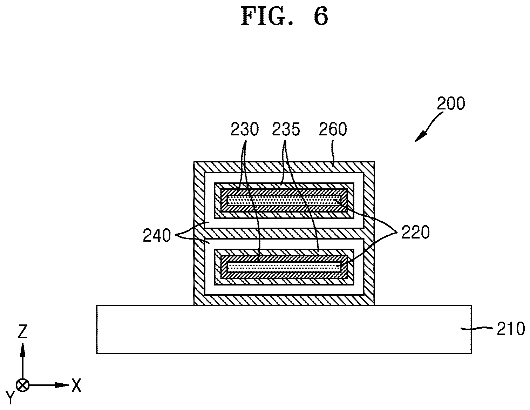

FIG. 4 is a perspective view illustrating a schematic structure of a semiconductor device according to an example embodiment, FIG. 5 is a cross-sectional view taken along line AA of FIG. 4, and FIG. 6 is a cross-sectional view taken along line BB of FIG. 4.

Referring to the drawings, a semiconductor device 200 may include a plurality of channel layers 220 arranged over a substrate 210, a source electrode 280 and a drain electrode 290, which are electrically connected to the channel layers 220, and a gate electrode 260 arranged apart from the channel layer 220.

The substrate 210 may be an insulating substrate or may be a semiconductor substrate with an insulating layer formed on a surface thereof. The semiconductor substrate may include, for example, Si, Ge, SiGe, or a III-V group semiconductor material. The substrate 210 may be, for example, a silicon substrate with a silicon oxide formed on a surface thereof; however, the disclosure is not limited thereto.

Over the substrate 210, the source electrode 280 and the drain electrode 290 may be arranged apart from each other in a first direction (Y direction), and the plurality of channel layers 220 may be arranged between the source electrode 280 and the drain electrode 290 apart from each other in a direction (Z direction) away from the substrate 210. The channel layer 220 may be arranged in a bridge shape between the source electrode 280 and the drain electrode 290. The gate electrode 260 may be arranged to surround each of the plurality of channel layers 220 at a position spaced apart from the channel layer 220.

A plurality of two-dimensional material oxide layers 230, a plurality of dipole oxide layers 235, and a plurality of dielectric layers 240 may be located between the gate electrode 260 and the plurality of channel layers 220. The plurality of two-dimensional material oxide layers 230 may be arranged to respectively surround the plurality of channel layers 220, the plurality of dipole oxide layers 235 may be arranged to respectively surround the plurality of two-dimensional material oxide layers 230, and the plurality of dielectric layers 240 may be arranged to surround the plurality of dipole oxide layers 235, respectively. The two-dimensional material oxide layer 230, the dipole oxide layer 235, and the dielectric layer 240 may be included in a gate insulating layer GI.

The materials of the channel 120, the two-dimensional material oxide layer 130, the dipole oxide layer 135, the dielectric layer 140, the gate electrode 160, the source electrode S, and the drain electrode D described above with reference to FIG. 1 may be used as materials of the channel layer 220, the two-dimensional material oxide layer 230, the dipole oxide layer 235, the dielectric layer 240, the gate electrode 260, the source electrode 280, and the drain electrode 290.

As illustrated in FIGS. 5 and 6, the two-dimensional material oxide layer 230, the dipole oxide layer 235, and the dielectric layer 240 may have a structure that surrounds the channel layer 220 with an axis parallel to the first direction (Y direction) as a central axis. The entire region of the channel layer 220 except the region contacting the source electrode 280 and the drain electrode 290 may contact the two-dimensional material oxide layer 230. The dipole oxide layer 235 may have a shape that surrounds the two-dimensional material oxide layer 230 with an axis parallel to the first direction (Y direction) as a central axis. The dielectric layer 240 may have a shape that surrounds the dipole oxide layer 235 with an axis parallel to the first direction (Y direction) as a central axis. As illustrated in FIG. 5, the dielectric layer 240 may extend along the side surfaces of the source electrode 280 and the drain electrode 290 such that the gate electrode 260 and the source electrode 280 are insulated from each other and the gate electrode 260 and the drain electrode 290 are insulated from each other.

The semiconductor device 200 according to an example embodiment may be a field effect transistor having a multi-bridge channel form. As described above, this form may reduce the short channel effect and/or may be advantageous for higher integration. Also, because the semiconductor device 200 may maintain a uniform source/drain junction capacitance regardless of the position of the channel, it may have the advantage of being applicable as a higher-speed and higher-reliability device. The semiconductor device 200 is illustrated as including two channel layers 220; however, this is an example and the disclosure is not limited thereto. Also, the contacts between each of the plurality of channel layers 220 and the source electrode 280 and the drain electrode 290 are illustrated as an edge contact form but is not limited thereto and may be modified into a planar contact form. Also, the shape of the source electrode 280 and the drain electrode 290 may also be modified into other shapes to be advantageous for contact with the channel layer 220.

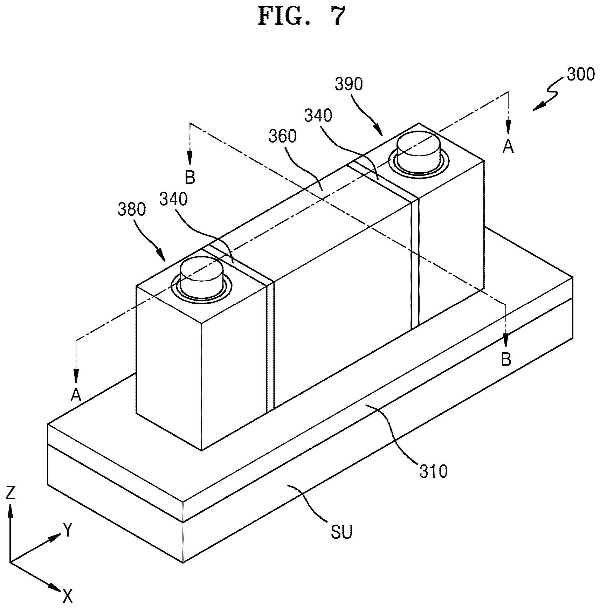

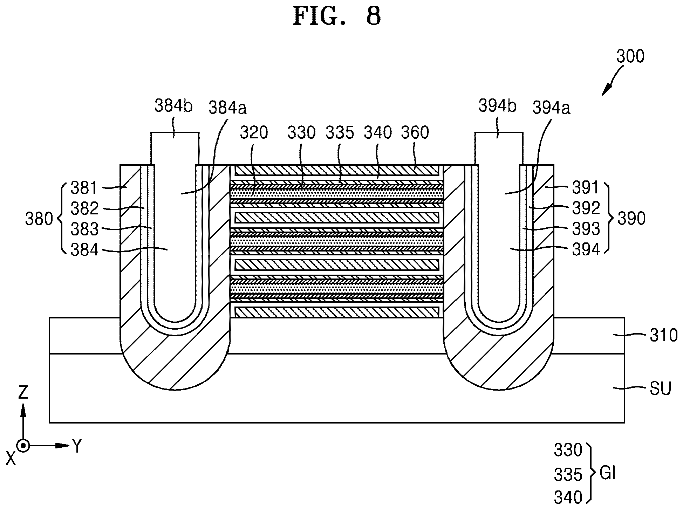

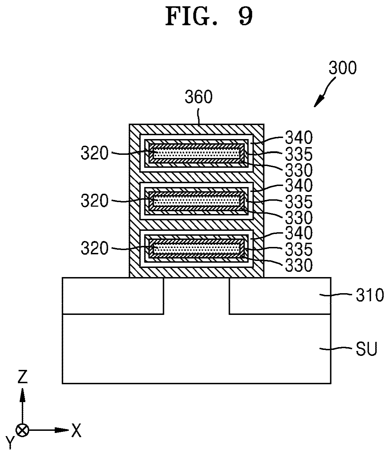

FIG. 7 is a perspective view illustrating a schematic structure of a semiconductor device according to an example embodiment. FIG. 8 is a cross-sectional view taken along line AA of FIG. 7, and FIG. 9 is a cross-sectional view taken along line BB of FIG. 7.

A semiconductor device 300 according to the present example embodiment may be similar to the semiconductor device 200 described above with reference to FIGS. 4 to 6 in that it is a field effect transistor in the form of a multi-bridge channel, and may be different therefrom in the detailed shapes of a source structure and a drain structure, and thus, differences therebetween will be mainly described.

The semiconductor device 300 may include a substrate SU, a plurality of channel layers 320 arranged over the substrate SU, and a gate electrode 360 spaced apart from each of the plurality of channel layers 320 and surrounding each of the plurality of channel layers 320 and may include a plurality of two-dimensional material oxide layers 330, a plurality of dipole oxide layers 335, and a plurality of dielectric layers 340 that surround the plurality of channel layers 320 between the gate electrode 360 and the plurality of channel layers 320. An insulating layer 310 functioning as a device isolation layer may be arranged over the substrate SU.

A source structure 380 including a source electrode 384 electrically connected to one end portion of each of the plurality of channel layers 320 and a drain structure 390 including a drain electrode 394 electrically connected to the other end portion of each of the plurality of channel layers 320 may be provided over the substrate SU.

The source structure 380 may include a semiconductor region 381, a silicide layer 382, a conductive barrier 383, and the source electrode 384. The source electrode 384 may include a first portion 384a surrounded by the semiconductor region 381 and a second portion 384b protruding over the semiconductor region 381. The first portion 384a of the source electrode 384 may be sequentially surrounded by the conductive barrier 383, the silicide layer 382, and the semiconductor region 381.

Like the source structure 380, the drain structure 390 may also include a semiconductor region 391, a silicide layer 392, a conductive barrier 393, and a drain electrode 394. The drain electrode 394 may include a first portion 394a surrounded by the semiconductor region 391 and a second portion 394b protruding over the semiconductor region 391. The first portion 394a of the drain electrode 394 may be sequentially surrounded by the conductive barrier 393, the silicide layer 392, and the semiconductor region 391.

The semiconductor region 381/382 may be arranged to protrude in the Z direction from the upper surface of the substrate SU. The semiconductor region 381/382 may contact the substrate SU by passing through the insulating layer 310. The semiconductor region 381/382 may include a relatively heavily doped n-type semiconductor or a relatively heavily doped p-type semiconductor. The semiconductor region 381/382 may include, for example, SiGe; however, the disclosure is not limited thereto. A portion of the semiconductor region 381/382 may be connected to the plurality of channel layers 320, and a portion of the semiconductor region 381/382 may have a width corresponding to at least the X-direction width of the channel layer 320.

The conductive barrier 383 may be arranged between the silicide layer 382 and the source electrode 384 to reduce or prevent gas or metal from diffusing into the silicide layer 382. For example, the conductive barrier 383 may reduce or prevent a gas material, which is used to deposit the source electrode 384, from contacting and reacting with the silicide layer 382 and/or may reduce or prevent the metal material of the conductive barrier 383 from diffusing into the silicide layer 382.

The conductive barrier 393 of the drain structure 390 may also be intended for a similar function to the conductive barrier 383 of the source structure 380.

The conductive barrier 383/393 may include a material that is not easily damaged because it has a relatively high physical and/or chemical stability. Also, in order to maintain the resistance of the source structure 380 and the drain structure 390 to be low, the conductive barrier 383/393 may include a material having relatively good electrical conductivity.

The conductive barrier 383/393 may include a conductive two-dimensional material such as graphene. In addition to graphene, various two-dimensional materials having conductivity may be used. For example, the two-dimensional material used as the conductive barrier 383/393 may include at least one selected from among graphene, black phosphorus, amorphous boron nitride, two-dimensional hexagonal boron nitride (h-BN), and phosphorene. When the two-dimensional material is used, the thickness of the conductive barrier 383/393 may be reduced and thus the performance of the semiconductor device 300 may be improved while further reducing the size of the semiconductor device 300. For example, the thickness of the conductive barrier 383/393 may be in a range of about 0.3 nm to about 2 nm.

The source electrode 384 and the drain electrode 394 may include, for example, at least one selected from among W, Co, Cu, Ru, Mo, Rh, and Ir, or any alloy thereof. In some example embodiments, each of the source electrode 384 and the drain electrode 394 may include the same conductive two-dimensional material as the conductive barrier 383/393. In this case, the source electrode 384 and the conductive barrier 383 may be integrally formed with each other, and the drain electrode 394 and the conductive barrier 393 may be integrally formed with each other.

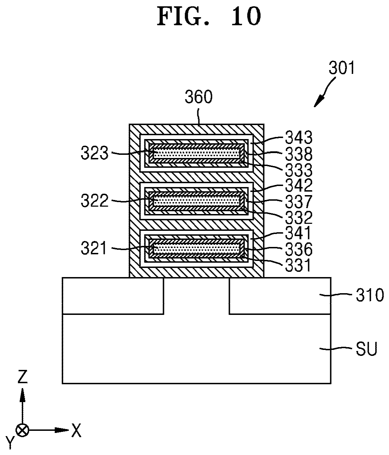

FIG. 10 is a cross-sectional view illustrating a schematic structure of a semiconductor device according to an example embodiment.

A semiconductor device 301 according to the present example embodiment may be different from the semiconductor device 300 described above with reference to FIG. 9 in that a plurality of channel layers 320 located on different layers may be different from each other, a plurality of two-dimensional material oxide layers 330 may be different from each other, a plurality of dipole oxide layers 335 may be different from each other, and a plurality of dielectric layers 340 may be different from each other.

The semiconductor device 301 may include a first channel layer 321, a second channel layer 322, and a third channel layer 323, may include a first two-dimensional material oxide layer 331, a first dipole oxide layer 336, and a first dielectric layer 341 that sequentially surround the first channel layer 321, may include a second two-dimensional material oxide layer 332, a second dipole oxide layer 337, and a second dielectric layer 342 that sequentially surround the second channel layer 322, and may include a third two-dimensional material oxide layer 333, a third dipole oxide layer 338, and a third dielectric layer 343 that sequentially surround the third channel layer 323.

The materials of gate insulating layers, that is, the first two-dimensional material oxide layer 331, the first dipole oxide layer 336, the first dielectric layer 341, the second two-dimensional material oxide layer 332, the second dipole oxide layer 337, the second dielectric layer 342, the third two-dimensional material oxide layer 333, the third dipole oxide layer 338, and the third dielectric layer 343, may be set such that at least two of the first channel layer 321, the second channel layer 322, and the third channel layer 323 exhibit different threshold voltages.

For example, in order for the first channel layer 321 and the second channel layer 322 to exhibit different threshold voltages, an electric dipole moment formed at the interface between the first two-dimensional material oxide layer 331 and the first dipole oxide layer 336 and an electric dipole moment formed at the interface between the second two-dimensional material oxide layer 332 and the second dipole oxide layer 337 may have different magnitudes and/or polarities. For this purpose, a material combination of the first two-dimensional material oxide layer 331 and the first dipole oxide layer 336 that are provided around each of the first channel layer 321 and a material combination of the second two-dimensional material oxide layer 332 and the second dipole oxide layer 337 that are provided around the second channel layer 322 may be different from each other.

A gate insulating layer material combination causing the threshold voltages of at least two of the first channel layer 321, the second channel layer 322, or the third channel layer 323 to be different may vary. For example, at least two of the first dipole oxide layer 336, the second dipole oxide layer 337, or the third dipole oxide layer 338 may include different materials. For example, the first dipole oxide layer 336 may include Y₂O₃, and the second dipole oxide layer 337 may include Al₂O₃. In some example embodiments, the first dipole oxide layer 336 may include ScO, and the second dipole oxide layer 337 may include MgO. In some example embodiments, all of the first dipole oxide layer 336, the second dipole oxide layer 337, and the third dipole oxide layer 338 may include the same material, and at least two of the first two-dimensional material oxide layer 331, the second two-dimensional material oxide layer 332, or the third two-dimensional material oxide layer 333 may include different transition metal oxides. For example, two of the first channel layer 321, the second channel layer 322, and the third channel layer 323 may include different TMD materials. Also, along with the material selection, the thicknesses of the layers included in the gate insulating layer GI may also be suitably set. For example, the thicknesses of at least two layers among the first two-dimensional material oxide layer 331, the second two-dimensional material layer 332, and the third two-dimensional material oxide layer 333 may be different from each other. In some example embodiments, the thicknesses of two layers among the first dipole oxide layer 336, the second dipole oxide layer 337, and the third dipole oxide layer 338 may be different from each other. When the thicknesses of the respective layers are different from each other, the total amount of oxygen ions moving in the interface between the two layers may vary and thus the dipole moment may vary.

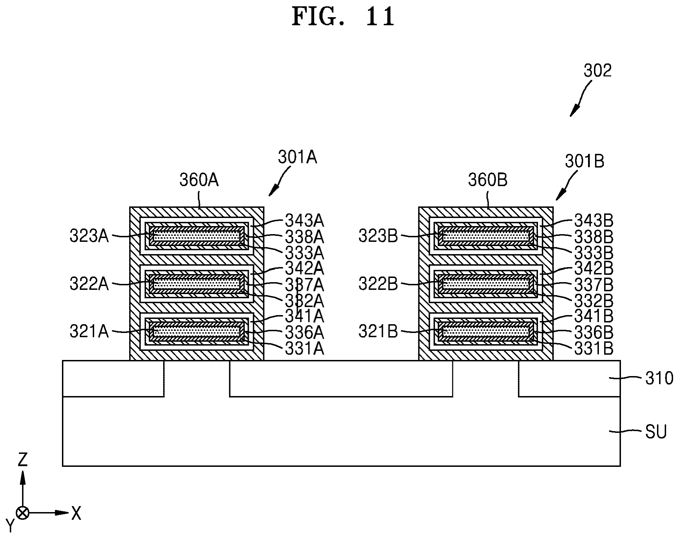

FIG. 11 is a cross-sectional view illustrating a schematic structure of an electronic apparatus according to an example embodiment.

An electronic apparatus 302 may include a first semiconductor device 301A and a second semiconductor device 301B.

The first semiconductor device 301A may include a first channel layer 321A, a second channel layer 322A, and a third channel layer 323A, may include a first two-dimensional material oxide layer 331A, a first dipole oxide layer 336A, and a first dielectric layer 341A that sequentially surround the first channel layer 321A, may include a second two-dimensional material oxide layer 332A, a second dipole oxide layer 337A, and a second dielectric layer 342A that sequentially surround the second channel layer 322A, and may include a third two-dimensional material oxide layer 333A, a third dipole oxide layer 338A, and a third dielectric layer 343A that sequentially surround the third channel layer 323A.

The second semiconductor device 301B may include a first channel layer 321B, a second channel layer 322B, and a third channel layer 323B, may include a first two-dimensional material oxide layer 331B, a first dipole oxide layer 336B, and a first dielectric layer 341B that sequentially surround the first channel layer 321B, may include a second two-dimensional material oxide layer 332B, a second dipole oxide layer 337B, and a second dielectric layer 342B that sequentially surround the second channel layer 322B, and may include a third two-dimensional material oxide layer 333B, a third dipole oxide layer 338B, and a third dielectric layer 343B that sequentially surround the third channel layer 323B.

The threshold voltage of the first semiconductor device 301A and the threshold voltage of the second semiconductor device 301B may be different from each other. Combinations of gate insulating layers respectively included therein may be different from each other such that the threshold voltage of the first semiconductor device 301A and the threshold voltage of the second semiconductor device 301B are different from each other. The first dipole oxide layer 336A, the second dipole oxide layer 337A, and the third dipole oxide layer 338A of the first semiconductor device 301A may include the same material. The first dipole oxide layer 336B, the second dipole oxide layer 337B, and the third dipole oxide layer 338B of the second semiconductor device 301B may include the same material. The material of the first dipole oxide layer 336A, the second dipole oxide layer 337A, and the third dipole oxide layer 338A of the first semiconductor device 301A and the material of the first dipole oxide layer 336B, the second dipole oxide layer 337B, and the third dipole oxide layer 338B of the second semiconductor device 301B may be different from each other. In some example embodiments, the materials of at least two of the first dipole oxide layer 336A, the second dipole oxide layer 337A, or the third dipole oxide layer 338A may be different from each other, and the materials of at least two of the first dipole oxide layer 336B, the second dipole oxide layer 337B, or the third dipole oxide layer 338B may be different from each other. In some example embodiments, the threshold voltages may be adjusted such that each of the first dipole oxide layer 336A, the second dipole oxide layer 337A, and the third dipole oxide layer 338A of the first semiconductor device 301A has a thickness of T1 and each of the first dipole oxide layer 336B, the second dipole oxide layer 337B, and the third dipole oxide layer 338B of the second semiconductor device 301B has a thickness of T2 that is different from T1. As such, the threshold voltage may be adjusted by differently adjusting at least one of the material or thickness of the layers included in the gate insulating layer. In some example embodiments, each of the first semiconductor device 301A and the second semiconductor device 301B may be substantially the same as any one of the semiconductor devices 300 or 301 described above.

Although the electronic apparatus 302 is illustrated as including two semiconductor devices with different threshold voltages, the disclosure is not limited thereto and the electronic apparatus 302 may include three or more semiconductor devices with different threshold voltages.

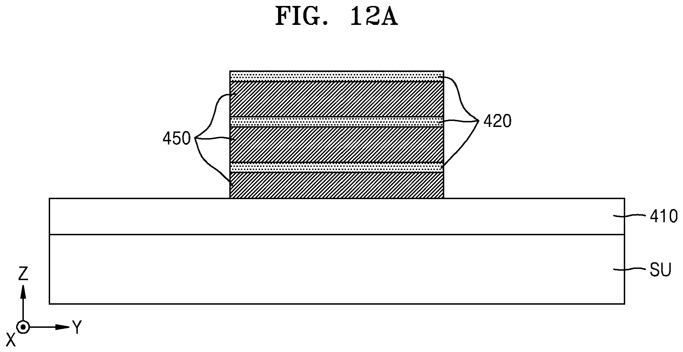

FIGS. 12A to 12G are diagrams describing a semiconductor device manufacturing method according to an example embodiment.

Referring to FIG. 12A, first, a dummy layer 450 and a channel layer 420 may be repeatedly stacked a plurality of times over a substrate SU. An insulating layer 410 functioning as a device isolation layer may be formed over the substrate SU, and a plurality of dummy layers 450 and a plurality of channel layers 420 may be alternately deposited over the insulating layer 410 as illustrated.

The dummy layer 450 may be a sacrificial layer that supports the plurality of channel layers 420 formed apart from each other and is removed after another structure supporting the channel layer 420 is formed. The dummy layer 450 may support the channel layer 420 and also may include a material having a different etch ratio than the channel layer 420 such that it may be selectively removed. The dummy layer 450 may be formed by a chemical vapor deposition (CVD) method or the like. The dummy layer 450 may include at least one of SiGe SiO₂, SiN, SiON, Al₂O₃, or HfO₂.

The channel layer 420 may include a two-dimensional semiconductor material and may include various channel (120) materials described above with reference to FIG. 1. The channel layer 420 may be formed by, for example, a method such as metal organic CVD (MOCVD), physical vapor deposition (PVD), or atomic layer deposition (ALD). The channel layer 420 may have a monolayer or multilayer structure including a two-dimensional semiconductor material. The thickness of the channel layer 420 may be greater than about 0 nm but not more than about 10 nm, not more than about 5 nm, not more than about 3 nm, or not more than about 1 nm. The channel layer 420 may have, for example, a three-layer structure of a TMD material. For example, the channel layer 420 may include a trilayer of MoS₂ but is not limited thereto.

The channel layer 420 may include a two-dimensional semiconductor material doped with a dopant of a certain conductivity type. The two-dimensional semiconductor material of the channel layer 420 may be doped with a p-type dopant or an n-type dopant. Here, for example, a p-type dopant and an n-type dopant used in graphene or carbon nanotube (CNT) may be used as the p-type dopant and the n-type dopant described above. The p-type dopant or the n-type dopant may be doped by using ion implantation or chemical doping.

A source of the p-type dopant may include, for example, an ionic liquid such as NO₂BF₄, NOBF₄, or NO₂SbF₆; an acidic compound such as HCl, H₂PO₄, CH₃COOH, H₂SO₄, or HNO₃; or an organic compound such as dichlorodicyanoquinone (DDQ), oxone, dimyristoylphosphatidylinositol (DMPI), or trifluoromethanesulfoneimide. In some example embodiments, the source of the p-type dopant may include HPtCl₄, AuCl₃, HAuCl₄, silver trifluoromethanesulfonate (AgOTf), AgNO₃, HPdCl₆, Pd(OAc)₂, Cu(CN)₂, or the like.

A source of the n-type dopant may include, for example, a reduction product of a substituted or unsubstituted nicotinamide; a reduction product of a compound which is chemically bound to a substituted or unsubstituted nicotinamide; or a compound including at least two pyridinium moieties in which a nitrogen atom of at least one of the pyridinium moieties is reduced. For example, the source of the n-type dopant may include nicotinamide mononucleotide-H (NMNH), nicotinamide adenine dinucleotide-H (NADH), or nicotinamide adenine dinucleotide phosphate-H (NADPH) or may include viologen. In some example embodiments, the source of the n-type dopant may include a polymer such as polyethylenimine (PEI). In some example embodiments, the n-type dopant may include an alkali metal such as K or Li. Moreover, the p-type dopant and n-type dopant materials described above are merely examples, and various other materials may be used as dopants.

A structure in which the dummy layer 450 and the channel layer 420 are alternately stacked may be first formed over the substrate SU and then may be patterned by a photolithography process to have a desired X-direction width and Y-direction width.

In FIG. 12A, the plurality of channel layers 420 are not limited to all including the same material. According to some example embodiments, some of the plurality of channel layers 420 may include different two-dimensional semiconductor materials and may include different types of TMD materials.

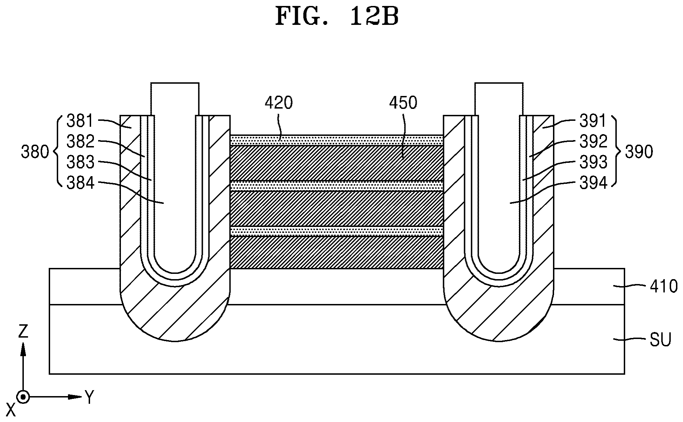

Referring to FIG. 12B, a source structure 380 and a drain structure 390 may be formed to contact both ends of the plurality of channel layers 420, respectively. The source structure 380 and the drain structure 390 may have the detailed structure as illustrated in FIG. 8.

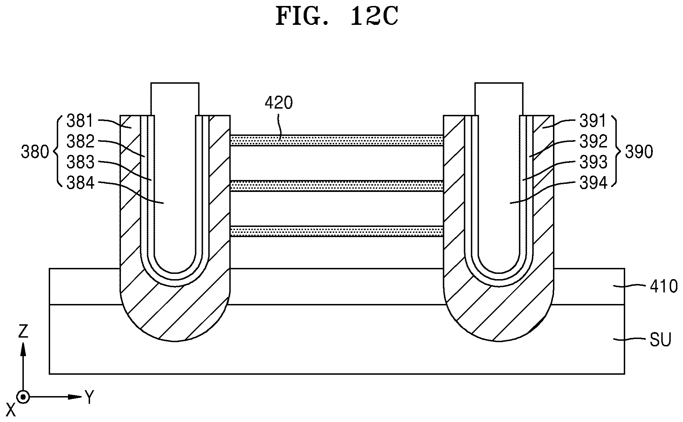

Next, the dummy layer 450 may be removed, and thus, a structure in which the plurality of channel layers 420 are supported in a bridge form between the source structure 380 and the drain structure 390 may be formed as illustrated in FIG. 12C. In order to remove the dummy layer 450, an etching gas selectively etching only the dummy layer 450 may be used.

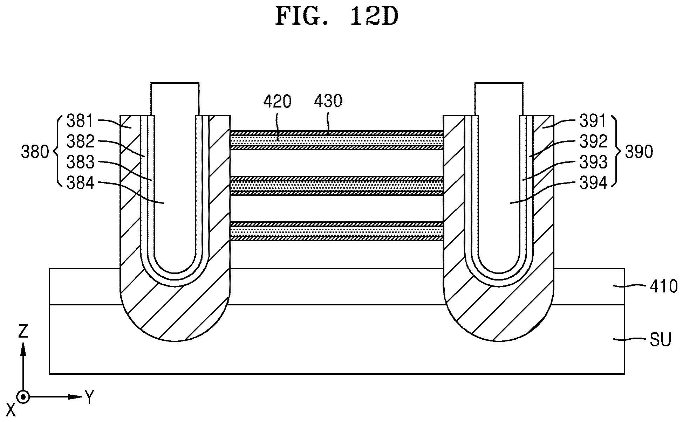

Next, as illustrated in FIG. 12D, a process of oxidizing the channel layer 420 may be performed. The oxidizing process may use heat treatment in an oxygen atmosphere, an oxygen plasma process, a UV ozone process, or the like. A portion of the surface of the channel layer 420 may be oxidized to form a two-dimensional material oxide layer 430. The process conditions thereof, that is, temperature, time, pressure, and/or the like, may be determined in consideration of the thickness of the two-dimensional material oxide layer 430.

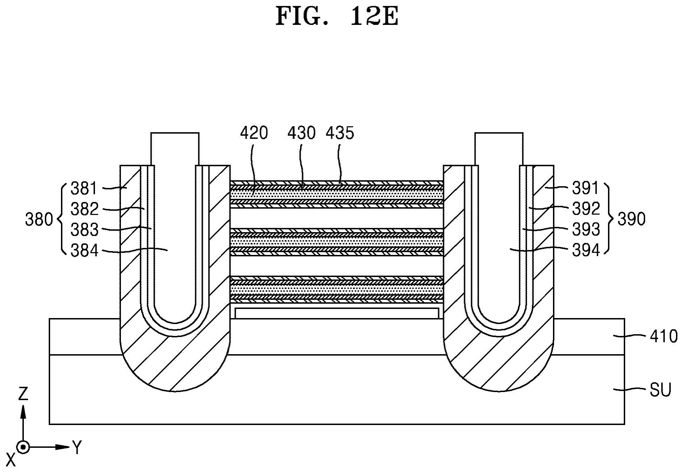

Referring to FIG. 12E, a dipole oxide layer 435 may be formed over the two-dimensional material oxide layer 430. The dipole oxide layer 435 may be formed by using a PVD, CVD, or ALD method. The dipole oxide layer 435 may surround the channel layer 420.

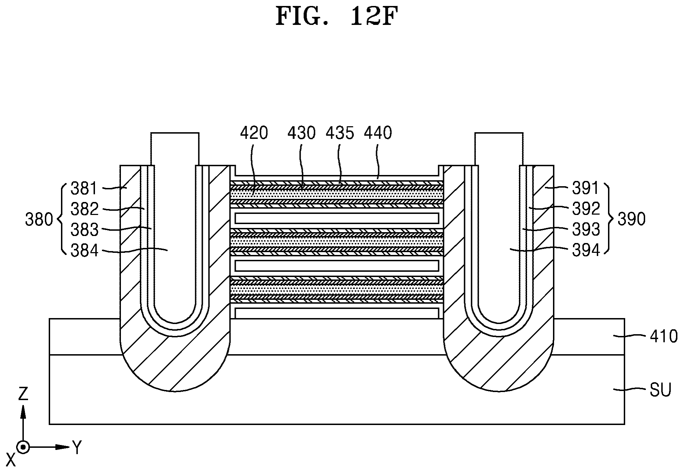

Next, as illustrated in FIG. 12F, a dielectric layer 440 may be formed over the dipole oxide layer 435. The dielectric layer 440 may include a high-k material. The dielectric layer 440 may surround the dipole oxide layer 435. The dielectric layer 440 may also extend onto the surfaces of the source structure 380 and the drain structure 390. For example, a method such as chemical vapor deposition (CVD), atomic layer deposition (ALD), or physical vapor deposition (PVD) may be used to form the dielectric layer 440.

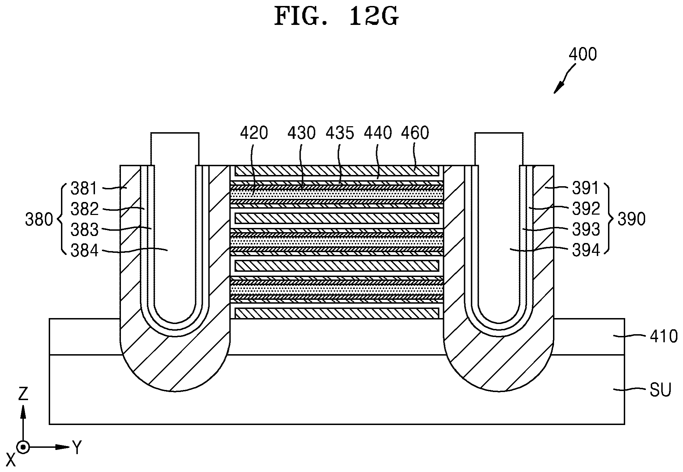

Next, an electrode material may be deposited over the dielectric layer 440 to form a gate electrode 460 as illustrated in FIG. 12G. For example, like the illustration in the cross-sectional view of FIG. 9 in a different direction from FIG. 12G, the gate electrode 460 may be formed to surround the channel layer 420, the two-dimensional material oxide layer 430, the dipole oxide layer 435, and the dielectric layer 440.

The manufacturing method described above with reference to FIGS. 12A to 12G is an example. The disclosure is not limited thereto and various other methods capable of forming the structure of the semiconductor device 100/200/300/301/400 described above may be used.

The semiconductor devices 100, 200, 300, 301, and 400 described above may be used in, for example, a driving integrated circuit of a display, a complementary metal oxide semiconductor (CMOS) inverter, a CMOS static random access memory (SRAM) device, a CMOS NAND circuit, and/or other various electronic apparatuses.

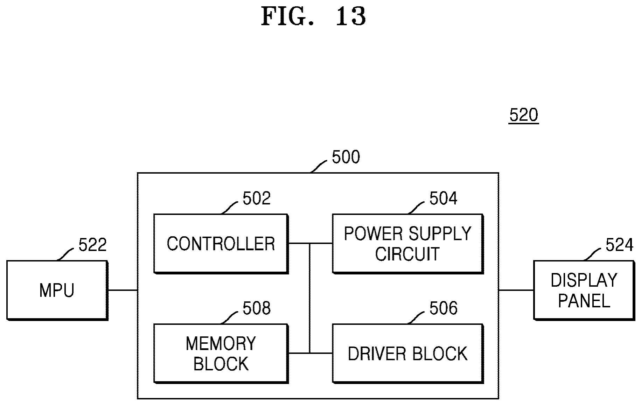

FIG. 13 is a schematic block diagram of a display apparatus 520 including a display driver integrated circuit (IC) (DDI) according to an example embodiment.

Referring to FIG. 13, a DDI 500 may include a controller 502, a power supply circuit 504, a driver block 506, and a memory block 508. The controller 502 may receive and decode a command applied from a main processing unit (MPU) 522 and control each of the blocks of the DDI 500 to implement an operation according to the command. The power supply circuit 504 may generate a driving voltage in response to control by the controller 502. The driver block 506 may drive a display panel 524 by using the driving voltage generated by the power supply circuit 504 in response to the control by the controller 502. The display panel 524 may be, for example, a liquid crystal display panel, an organic light emitting device (OLED) display panel, or a plasma display panel. The memory block 508 may be a block for temporarily storing commands input to the controller 502 or control signals output from the controller 502 or storing data and may include a memory such as a RAM and/or a ROM. The power supply circuit 504 and the driver block 506 may include any one of the semiconductor devices 100, 200, 300, 301, or 400 according to the example embodiments described above with reference to FIGS. 1 to 12G, or a semiconductor device as a modification or combination thereof.

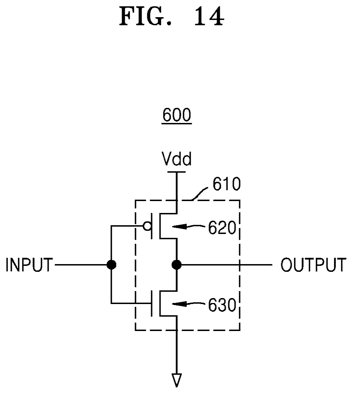

FIG. 14 is a circuit diagram of a CMOS inverter according to an example embodiment.

Referring to FIG. 14, a CMOS inverter 600 may include a CMOS transistor 610. The CMOS transistor 610 may include a PMOS transistor 620 and an NMOS transistor 630 connected between a power terminal Vdd and a ground terminal. The CMOS transistor 610 may include any one of the semiconductor devices 100, 200, 300, 301, or 400 according to the example embodiments described above with reference to FIGS. 1 to 12G, or a semiconductor device as a modification or combination thereof.

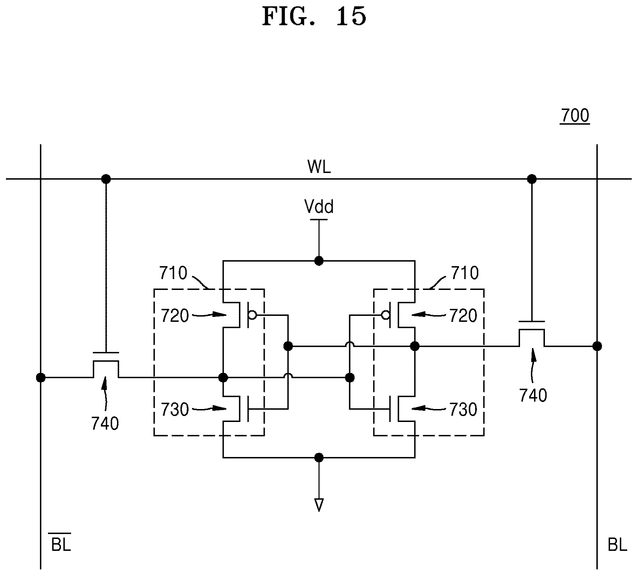

FIG. 15 is a circuit diagram of a CMOS SRAM device according to an example embodiment.

Referring to FIG. 15, a CMOS SRAM device 700 may include a pair of driving transistors 710. Each of the pair of driving transistors 710 may include a PMOS transistor 720 and an NMOS transistor 730 connected between a power terminal Vdd and a ground terminal. The CMOS SRAM device 700 may further include a pair of transmission transistors 740. A source of the transmission transistor 740 may be cross-connected to a common node of the PMOS transistor 720 and the NMOS transistor 730 constituting the driving transistor 710. The power terminal Vdd may be connected to a source of the PMOS transistor 720, and the ground terminal may be connected to a source of the NMOS transistor 730. A word line WL may be connected to gates of the pair of transmission transistors 740, and a bit line BL and an inverted bit line may be connected to drains of the pair of transmission transistors 740, respectively. At least one of the driving transistor 710 and the transmission transistor 740 of the CMOS SRAM device 700 may include any one of the semiconductor devices 100, 200, 300, 301, or 400 according to the example embodiments described above with reference to FIGS. 1 to 12G, or a semiconductor device as a modification or combination thereof.

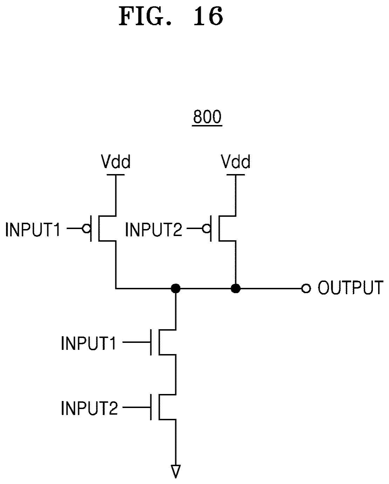

FIG. 16 is a circuit diagram of a CMOS NAND circuit according to an example embodiment.

Referring to FIG. 16, a CMOS NAND circuit 800 may include a pair of CMOS transistors to which different input signals are transmitted. The CMOS NAND circuit 800 may include the semiconductor device according to the example embodiments described above with reference to FIGS. 1 to 12G.

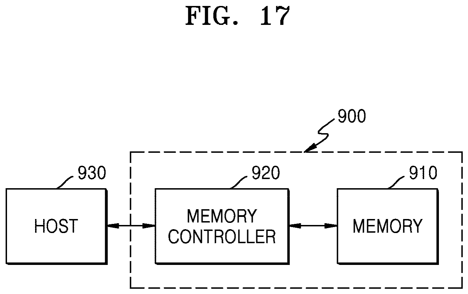

FIG. 17 is a block diagram of an electronic apparatus according to an example embodiment.

Referring to FIG. 17, an electronic apparatus 900 may include a memory 910 and a memory controller 920. The memory controller 920 may control the memory 910 to read data from the memory 910 and/or write data into the memory 910 in response to a request from a host 930. At least one of the memory 910 or the memory controller 920 may include any one of the semiconductor devices 100, 200, 300, 301, or 400 according to the example embodiments described above with reference to FIGS. 1 to 12G, or a semiconductor device as a modification or combination thereof.

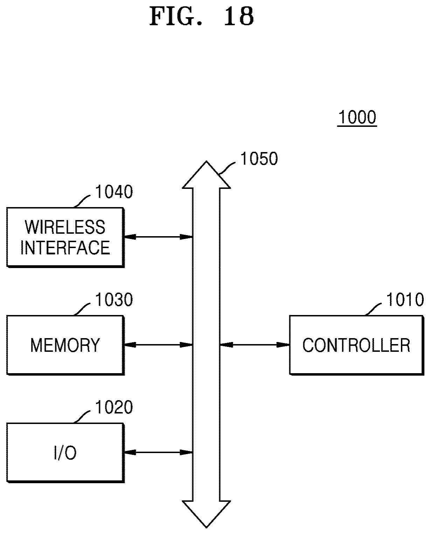

FIG. 18 is a block diagram of an electronic apparatus according to an example embodiment.

Referring to FIG. 18, an electronic apparatus 1000 may configure a wireless communication apparatus or an apparatus capable of transmitting and/or receiving information in a wireless environment. The electronic apparatus 1000 may include a controller 1010, an input/output (I/O) device 1020, a memory 1030, and a wireless interface 1040, which may be connected to each other through a bus 1050.

The controller 1010 may include at least one of a microprocessor, a digital signal processor, or any similar processing device. The I/O device 1020 may include at least one of a keypad, a keyboard, or a display. The memory 1030 may be used to store a command executed by the controller 1010. For example, the memory 1030 may be used to store user data. The electronic apparatus 1000 may use the wireless interface 1040 to transmit/receive data through a wireless communication network. The wireless interface 1040 may include an antenna and/or a wireless transceiver. In some example embodiments, the electronic apparatus 1000 may be used in the communication interface protocols of third-generation communication systems such as Code Division Multiple Access (CDMA), Global System for Mobile Communications (GSM), North American Digital Cellular (NADC), Extended Time Division Multiple Access (E-TDMA), and/or Wideband Code Division Multiple Access (WCDMA). The electronic apparatus 1000 may include any one of the semiconductor devices 100, 200, 300, 301, or 400 according to the example embodiments described above with reference to FIGS. 1 to 12G, or a semiconductor device as a modification or combination thereof.

The semiconductor device according to some example embodiments may exhibit good electrical performance with an ultra-small structure and thus may be applied to integrated circuit devices and may implement miniaturization, relatively low power, and/or relatively high performance.

The semiconductor device according to an example embodiment may have a miniaturized structure and may easily adjust a threshold voltage.

The semiconductor device according to an example embodiment may exhibit various threshold voltages, and thus may be easily applied to logic design and/or may be applied to various electronic apparatuses.

According to some example embodiments, a high-quality dielectric layer may be more stably deposited on a channel layer including a TMD material by implementing a primary insulator (e.g., a dipole oxide layer) by oxidizing the TMD channel layer and then, depositing a secondary insulator (e.g., a dielectric layer) thereon.

Any functional blocks shown in the figures and described above may be implemented in processing circuitry such as hardware including logic circuits, a hardware/software combination such as a processor executing software, or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that some example embodiments described herein should be considered in a descriptive sense only and not for purposes of limitation. Descriptions of features or aspects within each example embodiment should typically be considered as available for other similar features or aspects in other example embodiments. While one or more example embodiments have been described with reference to the figures, it will be understood by those of ordinary skill in the art that various changes in form and details may be made therein without departing from the scope as defined by the following claims.

## Claims

1. A semiconductor device comprising:
a channel including a two-dimensional semiconductor material;
a source electrode and a drain electrode electrically connected to both ends of the channel, respectively;
a two-dimensional material oxide layer on the channel;
a dipole oxide layer on the two-dimensional material oxide layer;
a dielectric layer on the dipole oxide layer; and
a gate electrode on the dielectric layer,
wherein the dipole oxide layer includes at least one of La₂O₃, Al₂O₃, ScO, Y₂O₃, or MgO, and
the dielectric layer includes at least one of HfO₂, ZrO₂, or HfZrO.

2. The semiconductor device of claim 1, wherein the dipole oxide layer is in direct contact with the two-dimensional material oxide layer.

3. The semiconductor device of claim 1 or 2, wherein the channel includes at least one of a transition metal dichalcogenide, TMD, material, graphene, black phosphorus, amorphous boron nitride, or phosphorene.

4. The semiconductor device of claim 3, wherein the TMD material includes a metal element selected from among Mo, W, Nb, V, Ta, Ti, Zr, Hf, Tc, Re, Cu, Ga, In, Sn, Ge, and Pb, and a chalcogen element selected from among S, Se, and Te, or
wherein the two-dimensional material oxide layer includes an oxide of a material included in the channel.

5. The semiconductor device of one of claims 1 to 4, wherein:
a thickness of the two-dimensional material oxide layer is greater than about 0 nm but not more than about 2 nm, or
a thickness of the dipole oxide layer is greater than about 0 nm but not more than about 2 nm, or
a thickness of the dielectric layer is greater than about 0 nm but not more than about 5 nm.

6. The semiconductor device of one of claims 1 to 5, further comprising:
a substrate supporting the channel,
wherein the gate electrode surrounds the channel while being apart from the channel, and
between the gate electrode and the channel, the two-dimensional material oxide layer surrounds the channel, the dipole oxide layer surrounds the two-dimensional material oxide layer, and the dielectric layer surrounds the dipole oxide layer.

7. The semiconductor device of claim 6, wherein
the channel comprises a first channel layer and a second channel layer spaced apart from each other in a direction away from the substrate,
the two-dimensional material oxide layer comprises a first two-dimensional material oxide layer surrounding the first channel layer and a second two-dimensional material oxide layer surrounding the second channel layer,
the dipole oxide layer comprises a first dipole oxide layer surrounding the first two-dimensional material oxide layer and a second dipole oxide layer surrounding the second two-dimensional material oxide layer, and
the dielectric layer comprises a first dielectric layer surrounding the first dipole oxide layer and a second dielectric layer surrounding the second dipole oxide layer.

8. The semiconductor device of claim 7, wherein the first two-dimensional material oxide layer, the first dipole oxide layer, the second two-dimensional material oxide layer, and the second dipole oxide layer are different in terms of at least one of material and thickness, or
wherein a first electric dipole moment at an interface between the first two-dimensional material oxide layer and the first dipole oxide layer and a second electric dipole moment at an interface between the second two-dimensional material oxide layer and the second dipole oxide layer are different in at least one of magnitude or polarity, or
wherein the first channel layer and the second channel layer include different materials from each other.

9. The semiconductor device of claim 6, comprising:
a source structure comprising the source electrode and connecting the source electrode to the channel; and
a drain structure comprising the drain electrode and connecting the drain electrode to the channel,
wherein the source structure and the drain structure are arranged over the substrate.

10. The semiconductor device of claim 9, wherein each of the source structure and the drain structure includes a semiconductor region, a silicide layer, and a conductive barrier.

11. An electronic apparatus comprising:
a substrate; and
a plurality of semiconductor devices according to one of claims 1 to 10 on the substrate.

12. The electronic apparatus of claim 11, wherein in each of the plurality of semiconductor devices,
the channel comprises a plurality of channel layers spaced apart from each other in a direction away from the substrate,
the two-dimensional material oxide layer comprises a plurality of two-dimensional material oxide layers surrounding the plurality of channel layers, respectively,
the dipole oxide layer comprises a plurality of dipole oxide layers surrounding the plurality of two-dimensional material oxide layers, respectively, and
the dielectric layer comprises a plurality of dielectric layers surrounding the plurality of dipole oxide layers, respectively.

13. The electronic apparatus of claim 11 or 12, wherein the plurality of semiconductor devices are different in terms of at least one of materials and thicknesses of the two-dimensional material oxide layer and the dipole oxide layer.

14. A method of manufacturing a semiconductor device, the method comprising:
alternately forming a dummy layer and a channel on a substrate to form a stack structure, the channel including a two-dimensional semiconductor material;
forming a source electrode and a drain electrode on both sides of the stack structure, respectively;
removing the dummy layer;
forming a two-dimensional material oxide layer on the channel;
forming a dipole oxide layer on the two-dimensional material oxide layer;
forming a dielectric layer on the dipole oxide layer; and
forming a gate electrode on the dielectric layer,
wherein the dipole oxide layer includes at least one of La₂O₃, Al₂O₃, ScO, Y₂O₃, or MgO, and
the dielectric layer includes at least one of HfO₂, ZrO₂, or HfZrO.

15. The method of claim 14, wherein the channel includes at least one of a transition metal dichalcogenide, TMD, material, graphene, black phosphorus, amorphous boron nitride, or phosphorene.
